# EUROPEAN PATENT APPLICATION

(11) **EP 4 766 100 A1**
(43) Date of publication of application: **24.06.2026**
(21) Application number: 25224073.4
(22) Date of filing: 16.12.2025
(51) Int. Cl.: H10F 39/00

(54) **IMAGE SENSING DEVICE AND IMAGING SYSTEM INCLUDING THE SAME**

(30) Priority: 17.12.2024 KR 20240188311
(71) Applicant: SK hynix Inc., Bubal-eub Icheon-si Gyeonggi-do 17336 (KR)
(72) Inventor: JANG, Jae Hyung, 17336 Icheon-si, Gyeonggi-do (KR)
(74) Representative: Isarpatent

(57) **Abstract**

Image sensing devices and imaging systems are disclosed. In an embodiment, an image sensing device includes: a first pixel group and a second pixel group, each of which includes a first pixel including a first active region with a first region size and a second pixel including a second active region with a second region size smaller than the first region size. Each of the first pixel and the second pixel may include an avalanche diode, an antireflective layer disposed on the avalanche diode, and a light receiving pattern disposed on the antireflective layer.

## Description

### TECHNICAL FIELD

The technology and implementations disclosed in this patent document generally relate to an image sensing device and an imaging system including the same.

### BACKGROUND

Recently, time of flight (TOF) technology has been gaining significant attention. TOF may include irradiating an object with pulsed light from a light source located in or around a sensor, receiving reflected light, measuring the time taken for the round trip. This time measurement is used to determine a distance between the object and the light source based on the principle of the constancy of light velocity. To ensure accurate TOF measurement, an immediate reaction is required when the reflected light is detected by a light-receiving element. Thus, a highly sensitive photoelectric conversion element is essential. To this end, single photon avalanche diodes (SPADs) manufactured using CMOS process technology has been actively researched and developed.

### SUMMARY

The disclosed technology can be implemented in some embodiments to provide an image sensing device designed to select either a high-sensitivity single photon avalanche diode (SPAD) or a low-sensitivity SPAD based on illuminance, receive light and measure a distance to a target object.

The disclosed technology can also be implemented in some embodiments to provide an imaging system designed to select a high-sensitivity SPAD and a low-sensitivity SPAD based on illuminance, and measure a distance to a target object using a second light beam reflected by the target object by irradiating a first light beam to the target object using a light source, through one among a SPAD having a high sensitivity and a SPAD having a low sensitivity.

The disclosed technology can also be implemented in some embodiments to provide an imaging system designed to address further issues beyond the aforementioned issues.

In an embodiment of the disclosed technology, an image sensing device may include: a first pixel group and a second pixel group, each of which includes a first pixel including a first active region with a first region size (or a first width) and a second pixel including a second active region with a second region size (or a second width) smaller than the first region size (or the first width). Each of the first pixel and the second pixel may include an avalanche diode, an antireflective layer disposed on the avalanche diode, and a light receiving pattern disposed on the antireflective layer.

In another embodiment, an imaging system may include: a light source configured to emit a first light beam to a target object; and an image sensing device including a first pixel group and a second pixel group, each of which includes a first pixel including a first active region with a first region size (or a first width) and a second pixel including a second active region (or a second width) with a second region size smaller than the first region size (or the first width). Each of the first pixel and the second pixel may receive a second light beam reflected by the target object, the first pixel of the first pixel group and the first pixel of the second pixel group may be disposed to be adjacent to each other, and the second pixel of the first pixel group and the second pixel of the second pixel group may be disposed to be adjacent to each other.

In some embodiments, a first pixel group and a second pixel group, each of which including a first pixel having a first region size (or a fist width) and a second pixel having a second region size (or a second width) smaller than the first region size (or the first width) are included, and a first pixel and a second pixel (SP) of each pixel group are selectively turned on/off according to an illuminance value of an environment around the image sensing device. For example, when an illuminance value is equal to or greater than a reference illuminance value, a second pixel of each pixel group is turned on and receives the light reflected by the target object, and when the illuminance value is smaller than the reference illuminance value, a first pixel (SP) of each pixel group is turned on and receives the light reflected by the target object. In this way, it is possible to measure a distance to the target object more precisely by considering the illuminance of the environment around the image sensing device.

In some embodiments, the first pixel of the first pixel group and the first pixel (SP) of the second pixel group may be disposed to be adjacent to each other, and the second pixel of the first pixel group and the second pixel of the second pixel group may be disposed to be adjacent to each other. Based on the above-described illuminance of the environment around the image sensing device, each of the first pixels (SP1, SP2, SP3, SP4) and the second pixels (SP1, SP2, SP3, SP4) are selectively operated, and because the first pixel of the first pixel group, the first pixel of the second pixel group, the second pixel of the first pixel group, and the second pixel (SP) of the second pixel group are disposed adjacent to one another, the light-receiving rate can be increased.

In some embodiments, in a low-light environment, because each of the first pixel of the first pixel group and the first pixel (SP) of the second pixel group generates digital data, and an image signal processor processes and sums each digital data generated by the first pixel of the first pixel group and the first pixel (SP) of the second pixel group, the accuracy of distance measurement can be improved.

In some embodiments, the first pixel group and the second pixel group, each of which includes the first pixel with the first region size (or a first width) and the second pixel with the second region size (or a second width) smaller than the first region size (or the first width), are included, and the first pixel and the second pixel (SP) of each pixel group may be selectively turned on or off according to whether a distance to the target object is long or short, thereby allowing for more precise distance measurement while considering the surrounding illuminance.

The effects that can obtained from the disclosed technology are not limited to those mentioned above, and other effects not explicitly stated may also be achieved.

### BRIEF DESCRIPTION OF THE DRAWINGS

FIG. 1 is a block diagram illustrating an imaging system based on an embodiment.
FIG. 2 is a plan view of a pixel array based on an embodiment.
FIG. 3 is an enlarged plan view of Q1 area in FIG. 2.
FIG. 4 is a cross-sectional view taken along A-A' line in FIG. 3.
FIG. 5 illustrates a direct ToF method of a pixel (SP).
FIG. 6 illustrates an indirect ToF method of a pixel (SP).
FIG. 7 illustrates an imaging system based on an embodiment.
FIG. 8 illustrates a mode of a single photon avalanche diode based on an embodiment.
FIG. 9 is a graph converting pixel data generated by a second pixel (SP) based on an embodiment into a histogram.
FIG. 10 is a graph converting pixel data generated by a fourth pixel (SP) based on an embodiment into a histogram.
FIG. 11 is a view illustrating an imaging system based on an embodiment.
FIG. 12 is a view illustrating an imaging system under illuminance lower than a reference illuminance value.
FIG. 13 is a plan view illustrating a channel region irradiating a first light beam of a light source based on an embodiment.
FIG. 14 is a plan view illustrating irradiation of a second light beam to a pixel array based on an embodiment.
FIG. 15 is a graph illustrating a histogram obtained by summing pixel data generated by a second pixel (SP) of pixel groups based on an embodiment.
FIG. 16 is a view illustrating an imaging system under illuminance equal to or greater than a reference illuminance value.
FIG. 17 is a graph illustrating a histogram obtained by summing pixel data generated by a fourth pixel (SP) of pixel groups based on an embodiment.
FIG. 18 is a block diagram illustrating an imaging system based on another embodiment.
FIG. 19 is a view illustrating an imaging system based on another embodiment.
FIGS. 20 and 21 are graphs illustrating histograms of pixel data generated by an illuminance pixel (SP).

### DETAILED DESCRIPTION

Section headings are used in the present document only for ease of understanding and do not limit scope of the embodiments to the section in which they are described.

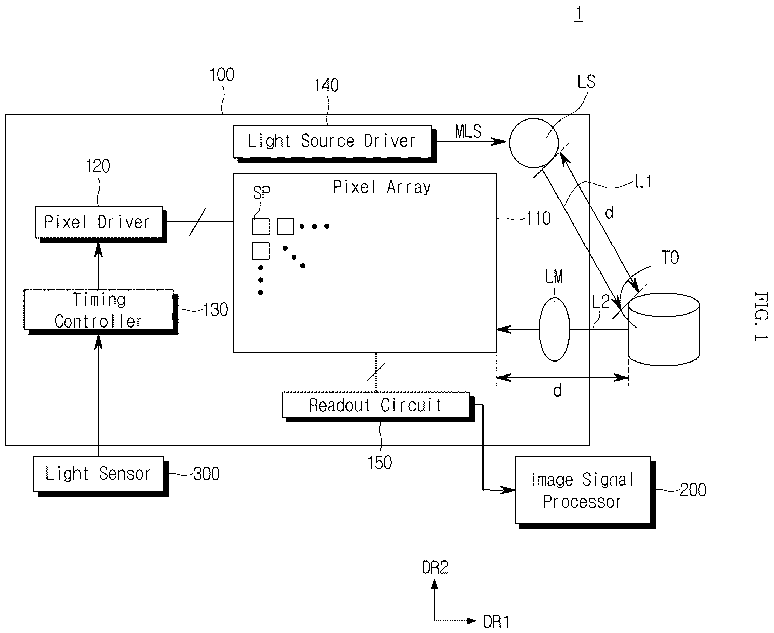

FIG. 1 is a block diagram illustrating an imaging system based on an embodiment.

Referring to FIG. 1, the imaging system 1 may refer to a device, for example, a digital still camera for photographing still images or a digital video camera for photographing moving images. For example, the imaging system 1 may be implemented as a Digital Single Lens Reflex (DSLR) camera, a mirrorless camera, or a mobile phone (e.g., smartphone), but is not limited thereto. The imaging system 1 may include a device having a lens and an image pickup element such that the device can capture a target object and can thus create an image of the target object.

The imaging system 1 may include an image sensing device 100 and an image signal processor 200.

The image sensing device 100 may measure a distance using a principle of TOF (Time of Flight). The image sensing device 100 may include a light receiving pattern LM, a pixel array 110, a pixel driver 120, a timing controller 130, a light source driver 140, and a readout circuit 150. The imaging system 1 based on an embodiment of the disclosed technology may further include a light sensor 300. The imaging system 1 may further include a light source LS. In some implementations, the light sensor 300 may refer to a photodetector that can detect light, measure illuminance, respond to changes in the amount of light received, and/or convert light to electricity.

The light source LS may irradiate light to a target object TO in response to a clock signal (e.g., a reference pulse signal MLS) from the light source driver 140. The light source LS may include a laser diode LD for emitting light having a specific wavelength such as an infrared light or a visible light, a light emitting diode (LED), a near infrared laser (NIR), a point light source, a white light lamp, a monochromatic illuminator in which a monochromator is combined, other laser light source LS and a combination thereof. For example, the light source LS may emit an infrared light having a wavelength of 800 nm to 1,000 nm. FIG. 1 shows one light source LS for convenience of description; however, a plurality of light sources LS may be disposed around the light receiving pattern LM. Alternatively, a plurality of the light sources LS may be arranged around the light receiving pattern LM. In an embodiment, a VCSEL (Vertical cavity surface emitting laser) including a point light source has been given as an example of the light source LS, but the disclosed technology is not limited thereto.

The light receiving pattern LM may collect light reflected from the target object TO and may focus the light onto pixels (SP1, SP2, SP3, SP4) of the pixel array 110. The light receiving pattern LM may include a focusing lens having a glass or plastic surface, or another cylindrical optical element. The light receiving pattern LM may include one lens group formed by at least one lens.

The pixel array 110 may include a plurality of pixels (SP1, SP2, SP3, SP4) disposed continuously in a two-dimensional matrix structure. That is, the pixel array 110 may include a plurality of pixels (SP) disposed continuously along a first direction DR1 and a second direction DR2 perpendicular to the first direction DR1. Each pixel (SP1, SP2, SP3, SP4) may include a pixel region. Each pixel (SP) may photoelectrically convert a second light beam L2 (or incident light) received through the light receiving pattern LM and may generate and output a pixel signal, which is an electric signal, corresponding to the second light beam L2. Here, the pixel signal may be a signal indicating information corresponding to a distance to the target object TO, rather than a signal indicating a color with respect to the target object TO. Each of the plurality of pixels may include a single photon avalanche diode.

The pixel array 110, in which the plurality of pixels SP are disposed, may detect a distance to the target object TO using the direct ToF method. The direct ToF is a method for calculating a distance to the target object TO by directly measuring a round-trip time from a time point when the pulse light is irradiated to the target object TO to a time point when the pulse light is reflected from the target object TO and returns, and calculating the reciprocation time and light velocity. However, the disclosed technology is not limited thereto, and the pixel array 110, in which the plurality of pixels SP are disposed, may detect a distance to the target object TO using an indirect ToF method. In one example, the indirect ToF method can measure distance using light by detecting the phase shift of a continuous modulated light wave reflected from an object, rather than directly measuring the time it takes for a light pulse to travel to and from the object.

The pixel driver 120 may drive the pixel array 110 according to the control of the timing controller 130. For example, the pixel driver 120 may generate a quenching control signal for controlling a quenching operation, which reduces a reverse bias voltage applied to the pixel SP to a breakdown voltage or less. That is, the pixel driver 120 may control turning on/off of the pixel SP in response to control signals of the timing controller 130.

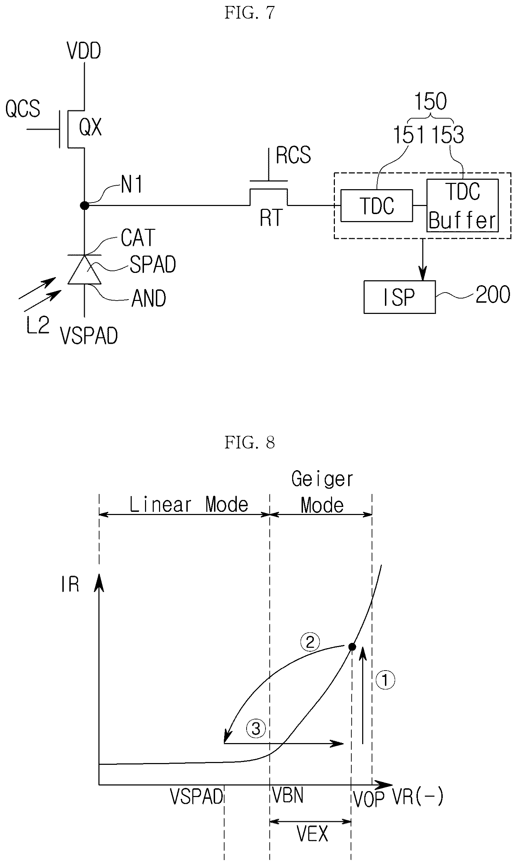

The readout circuit 150 is disposed on one side of the pixel array 110, and may calculate a time delay between a pulse signal (or a pixel signal) output from each pixel SP and a reference pulse, and generate (refer to a TDC (time-to-digital conversion) section 151 of the readout circuit 150 in FIG. 7) digital data (pixel data) corresponding to the time delay, and store (refer to a TDC buffer 153 of the readout circuit 150 in FIG. 7) the digital data. The readout circuit 150 may transmit the stored digital data to the image signal processor 200 according to the control of the timing controller 130.

The timing controller 130 may control the overall operations of the image sensing device 100. That is, the timing controller 130 may generate a timing signal for controlling the operation of the pixel driver 120 and the light source driver 140. In addition, the timing controller 130 may control activation or inactivation of the readout circuit 150, and may control to transmit digital data stored in the readout circuit 150 to the image signal processor 200 simultaneously or sequentially.

The light source driver 140 may generate a clock signal capable of operating the light source LS according to the control of the timing controller 130.

The image signal processor 200 may process digital data (or pixel data) input from the image sensing device 100, and generate a depth image (e.g., in the form of a histogram) representing a distance to the target object TO. In some implementations, the image signal processor 200 may calculate a distance to the target object TO per pixel based on the time delay represented by the digital data received from the readout circuit 150.

The image signal processor 200 may control operations of the image sensing device 100. In one example, the image signal processor 200 may analyze digital data input from the image sensing device 100 to determine a mode of the image sensing device 100, and may control the image sensing device 100 to operate in the determined mode.

The image signal processor 200 may perform image signal processing for removing noise and improving the image quality with respect to the generated depth image. The depth image output from the image signal processor 200 may be stored in an internal memory or an external memory of the imaging system 1 or a device in which the imaging system 1 is embedded, or may be displayed through the display at the request of the user or automatically. Alternatively, the depth image output from the image signal processor 200 may be used for controlling the operation of the imaging system 1 or the device in which the imaging system 1 is embedded.

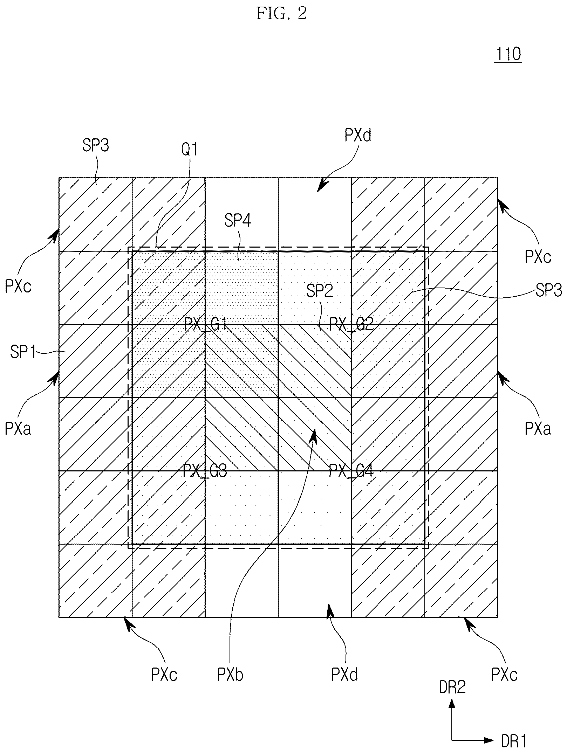

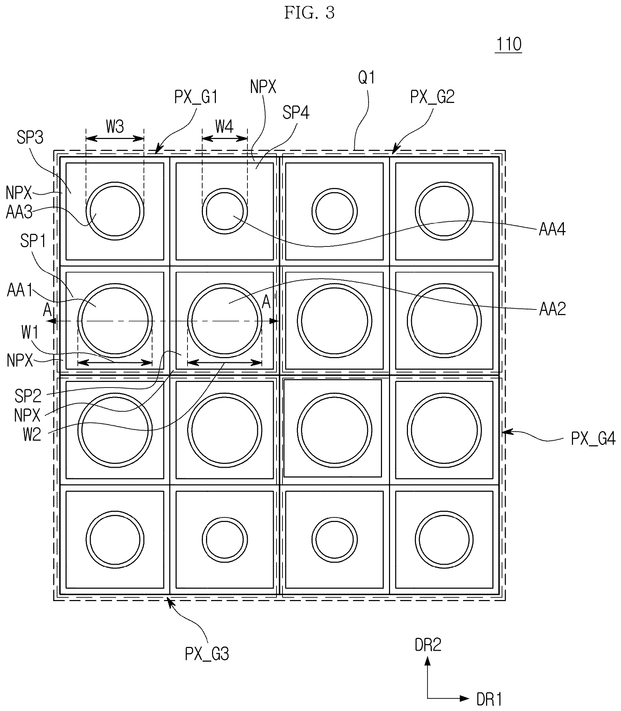

FIG. 2 is a plan view of the pixel array based on an embodiment. FIG. 3 is an enlarged plan view of Q1 area in FIG. 2. Referring to FIGS. 2 and 3, the pixel array 110 may include the plurality of pixels (SP1, SP2, SP3, SP4), and each pixel (SP1, SP2, SP3, SP4) may include a pixel region PX (in FIG. 1) and a non-pixel region NPX. The plurality of pixel regions may include a first pixel region PX1, a second pixel region PX2, a third pixel region PX3, and a fourth pixel region PX4, but the disclosed technology is not limited thereto. For example, the plurality of pixels (SP1, SP2, SP3, SP4) may form a plurality of pixel groups. For example, the pixel array 110 may include a plurality of pixel groups. For example, the plurality of pixel groups may include a first pixel group (PX_G1), a second pixel group (PX_G2), a third pixel group (PX_G3), and a fourth pixel group (PX_G4), but the disclosed technology is not limited thereto.

Each pixel group (PX_G1 to PX_G4) may include the first to fourth pixels (SP). The first to fourth pixels (SP) may be divided according to an area (or a width) of active regions (AA1, AA2, AA3, AA4) of the pixel regions (PX1, PX2, PX3, PX4) of each pixel (SP1, SP2, SP3, SP4). In FIG. 2, the active areas are shown to have a circle shape, but the shape of the active areas is not limited thereto.

For example, each of areas or sizes of the regions (or width W1, W2) of the first active region AA1 and the second active region AA2 is greater than an area (or a width W3) of the third active region AA3, and the area (or the width W3) of the third active region AA3 is greater than an area (or a width W4) of the fourth active region AA4. The width W1 of the first active region AA1 and the width W2 of the second active region AA2 may be the same, but the disclosed technology is not limited thereto.

As illustrated in FIG. 2, pixels of each pixel group (PX_G1 to PX_G4) may be disposed adjacent to the same pixels of an adjacent pixel group (PX_G1 to PX_G4).

For example, the first pixel group (PX_G1) may include a third pixel SP3 positioned on another side in the first direction DR1 and on one side in a second direction DR2, a fourth pixel SP4 positioned on one side in the first direction DR1 and on one side in the second direction DR2, a first pixel SP1 positioned on another side in the first direction DR1 and on another side in the second direction DR2, and a second pixel SP2 positioned on one side in the first direction DR1 and on another side in the second direction DR2.

For example, the second pixel group (PX_G2) may include a fourth pixel SP4 positioned on another side in the first direction DR1 and on one side in a second direction DR2, a third pixel SP3 positioned on one side in the first direction DR1 and on one side in the second direction DR2, a second pixel SP2 positioned on another side in the first direction DR1 and on another side in the second direction DR2, and a first pixel SP1 positioned on one side in the first direction DR1 and on another side in the second direction DR2.

For example, the third pixel group (PX_G3) may include a first pixel SP1 positioned on another side in the first direction DR1 and on one side in a second direction DR2, a second pixel SP2 positioned on one side in the first direction DR1 and on one side in the second direction DR2, a third pixel SP3 positioned on another side in the first direction DR1 and on another side in the second direction DR2, and a fourth pixel SP4 positioned on one side in the first direction DR1 and on another side in the second direction DR2.

For example, the fourth pixel group (PX_G4) may include a second pixel SP2 positioned on another side in the first direction DR1 and on one side in a second direction DR2, a first pixel SP1 positioned on one side in the first direction DR1 and on one side in the second direction DR2, a fourth pixel SP4 positioned on another side in the first direction DR1 and on another side in the second direction DR2, and a third pixel SP3 positioned on one side in the first direction DR1 and on another side in the second direction DR2.

As illustrated in FIG. 2, the first pixels (SP1) of each pixel group (PX_G1 to PX_G4) may be disposed to be adjacent to each other (refer to PXa), the second pixels (SP2) of each pixel group (PX_G1 to PX_G4) may be disposed to be adjacent to each other (refer to PXb), the third pixels (SP3) of each pixel group (PX_G1 to PX_G4) may be disposed to be adjacent to each other (refer to PXc), and the fourth pixels (SP4) of each pixel group (PX_G1 to PX_G4) may be disposed to be adjacent to each other (refer to PXd).

That is, according to the pixel array 110 according to the disclosed technology, pixels (SP1 to SP4), of which the active regions (AA1, AA2, AA3, AA4) have the same width (or area), may be disposed to be adjacent to each other.

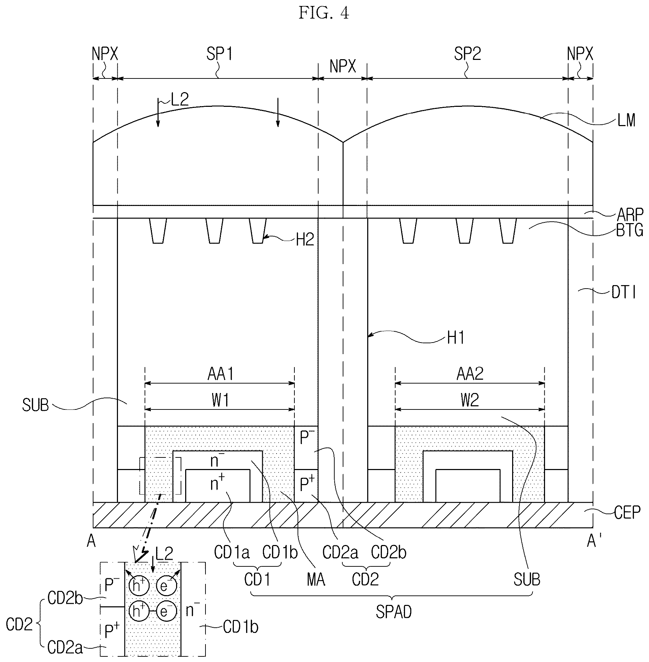

A cross-sectional structure of each pixel region (PX1 to PX4) will be described with reference to FIG. 4.

FIG. 4 is a cross-sectional view taken along A-A' line in FIG. 3. In FIG. 4, only the cross-sectional structure of the first pixel region (PX1) and the second pixel region (PX2) are illustrated as an example, however, the cross-sectional structure of the first and the second pixel regions (PX1, PX2) may be applied to the third and the fourth pixel regions (PX3, PX4) as well. As illustrated referring to FIGS. 2 and 3, the width W1 of the first active region AA1 and the width W2 of the second active region AA2 may be the same.

Referring to FIG. 4, the pixel array 110 based on an embodiment may include a circuit portion CEP, a single photon avalanche diode SPAD on the circuit portion CEP, a first trench portion DTI and a second trench portion BTG inside the single photon avalanche diode SPAD, an antireflective layer ARP on the single photon avalanche diode SPAD, and the light receiving pattern LM on the antireflective layer ARP. In some implementations, a single photon avalanche diode (SPAD) can refer to a photodetector such as a photodiode that can detect a single photon based on an avalanche phenomenon to generate a significantly large current from a small amount of incident light.

The circuit portion CEP may be disposed below the single photon avalanche diode SPAD, and may include transistors, a wiring layer, and an inter-layer insulating layer. The transistors may include a readout transistor, an analog quenching transistor formed below the single photon avalanche diode SPAD, and the like. The transistors will be described by referring to FIG. 7 below.

The single photon avalanche diode SPAD may include a first semiconductor region CD1, a second semiconductor region CD2, an intermediate region MA between the first semiconductor region CD1 and the second semiconductor region CD2, and a substrate portion SUB on the second semiconductor region CD2 and the intermediate region MA.

The first semiconductor region CD1 may be an n-type semiconductor region, and the second semiconductor region CD2 may be a p-type semiconductor region. For example, the p-type ions may include boron (B) ions, and the n-type ions may include phosphorous (P) and/or arsenic (As) ions. For example, the first semiconductor region CD1 may include a 1-1 semiconductor region CD1a which is an n+ type semiconductor region on the circuit portion CEP, and a 1-2 semiconductor region CD1b which is an n- type semiconductor region on the 1-1 semiconductor region CD1a, and the second semiconductor region CD2 may include a 2-1 semiconductor region CD2a which is an p+ type semiconductor region on the circuit portion CEP, and a 2-2 semiconductor region CD2b which is an p- type semiconductor region on the 2-1 semiconductor region CD2a.

For example, the 1-1 semiconductor region CD1a may have a higher doping concentration of an n-type impurity compared to that of the 1-2 semiconductor region CD1b, and the 2-1 semiconductor region CD2a may have a higher doping concentration of a p-type impurity compared to that of the 2-2 semiconductor region CD2b, however, the disclosed technology is not limited thereto, and the first semiconductor region CD1 and the second semiconductor region CD2 may have one n-type semiconductor region and one p-type semiconductor region respectively.

In some embodiments, vertical positions of the 1-1 semiconductor region CD1a and the 1-2 semiconductor region CD1b may be changed, and vertical positions of the 2-1 semiconductor region CD2a and the 2-2 semiconductor region CD2b may be changed.

The intermediate region MA may be disposed between the first semiconductor region CD1 and the second semiconductor region CD2. The intermediate region MA may be disposed on an upper surface of the first semiconductor region CD1. The mechanism of electrons (e-) and holes (h+) in the intermediate region MA will be described below.

The substrate portion SUB may be disposed on the intermediate region MA and the second semiconductor region CD2. The substrate portion SUB may include an n-type semiconductor region or a p-type semiconductor region. However, the doping concentration of the impurity of the substrate portion SUB may be lower than those of the first semiconductor region CD1 and the second semiconductor region CD2, respectively.

A first groove H1 may be formed in the non-pixel region NPX of the substrate portion SUB. The first groove H1 may be indented in a thickness direction in the substrate portion SUB. For example, the first groove H1 may penetrate the substrate portion SUB from an upper surface to a lower surface thereof completely. The first trench portion DTI may be formed in the first groove H1. The first trench portion DTI may be formed by a deep trench process. The first trench portion DTI may fill the first groove H1 completely.

In the pixel regions (PX1, PX2) of the substrate portion SUB, a second groove H2 may be formed, and one or two second grooves H2 may be provided, or three or more second grooves H2 may be provided. The second trench portion BTG may be disposed in the second groove H2, and therefore, one or two second trench portions BTG may be provided, or three or more second trench portions BTG may be provided. The first trench portions DTI and the second trench portion BTG may include the same material. For example, the first trench portions DTI and the second trench portion BTG may include an insulation material. For example, examples of the insulation material are hafnium oxide (HfO2) or silicon oxide (SiO2), but are not limited thereto. A refraction index of the first trench portion DTI may be, for example, about 1.4 to about 2.0, but is not limited thereto. The first trench portion DTI may serve to totally reflect the second light beam L2 (or the incident light) incident to the first trench portion DTI to the single photon avalanche diode SPAD. The second trench portion BTG may serve to scatter the second light beam L2 incident from the light receiving pattern LM. Each of the first trench portion DTI and the second trench portion BTG may serve to increase an optical path by totally reflecting the light to the single photon avalanche diode SPAD, or scatter the light. Because of this, they serve to improve the efficiency of the photoelectric conversion. In some embodiments, it may be designed in that the first trench portion DTI includes poly silicon (Poly Si), and the above-described insulation material is formed on a side wall of the poly silicon, but the disclosed technology is not limited thereto.

The antireflective layer ARP may be disposed on the single photon avalanche diode SPAD and the first trench portion DTI. The antireflective layer ARP may be in direct contact with the single photon avalanche diode SPAD and the first trench portion DTI. The antireflective layer ARP may include the same material as that of the first trench portion DTI, but the disclosed technology is not limited thereto. The antireflective layer ARP may be formed in the same process as the first trench portion DTI, and may be integrally connected with the first trench portion DTI. The antireflective layer ARP may serve to prevent the light incident from the light receiving pattern LM from being totally reflected on the single photon avalanche diode SPAD. To this end, the antireflective layer ARP may have a refraction index between a refraction index of the light receiving pattern LM and a refraction index of the single photon avalanche diode SPAD, but is not limited thereto. For example, the refraction index of the antireflective layer ARP may be about 1.4 to about 2.0, but is not limited thereto.

The light receiving pattern LM may be disposed on the antireflective layer ARP. The light receiving pattern LM may serve to allow the light incident from the outside to be received by each pixel region (PX1, PX2). To this end, the light receiving pattern LM may have a shape of a convex lens convex upward, and may be formed of a material having a big difference in the refraction index compared to that of the outside air. For example, the infraction index of the light receiving pattern LM may be about 1.5 to about 1.7, but is not limited thereto. As illustrated in FIG. 4, the light receiving pattern LM may be disposed continuously in the pixel region (PX1, PX2) and the non-pixel region (NPX), and an end of the convex lens shape may be positioned at a center of the pixel region (PX1, PX2), but is not limited thereto. For example, the light receiving pattern LM may be discontinued in the non-pixel region (NPX), and in this case, each of the plurality of light receiving patterns (LM) may be disposed in each of the pixel regions (PX1, PX2).

Though not illustrated, in some implementations, a grid portion may be disposed on the antireflective layer ARP of the non-pixel region (NPX). The grid portion may include an air structure or a reflective metal, but the disclosed technology is not limited thereto.

The single photon avalanche diode SPAD may be used as a photoelectric conversion element including a photosensitive p-n junction. That is, the single photon avalanche diode SPAD may detect a single photon (a single photon of L2) reflected by the target object (refer to TO in FIG. 1), and may generate pixel data (or a current pulse, a pixel signal, a pulse signal) corresponding to the detected single photon. At this instance, the pixel data may be generated through a series of processes as the avalanche breakdown is triggered by a single photon incident in a Geiger mode in which a reverse bias voltage higher than a breakdown voltage is applied as a voltage between a cathode and an anode. Here, the avalanche breakdown may occur in the intermediate region MA inside the single photon avalanche diode SPAD. A hole (h+) may be disposed in one region adjacent to the second semiconductor region CD2 of the intermediate region MA, and an electron (e-) may be disposed in another region adjacent to the first semiconductor region CD1 of the intermediate region MA. The hole (h+) in one region and the electron (e-) in another region may form an electron-hole pair to be combined with each other. The electron (e-)-hole (h+) pair may be impact-ionized by a photon of the second light beam L2.

In some implementations, when increasing the electric field by applying the reverse bias voltage to the single photon avalanche diode SPAD, the impact ionization, by which the electron (e-)-hole (h+) pair is generated while the electron (e-) generated attributable to the photon incident due to the strong electric field moves, occurs. As the electron (e-) and the hole (h+) generated due to the impact ionization phenomenon collide with each other, a lot of carriers may be generated.

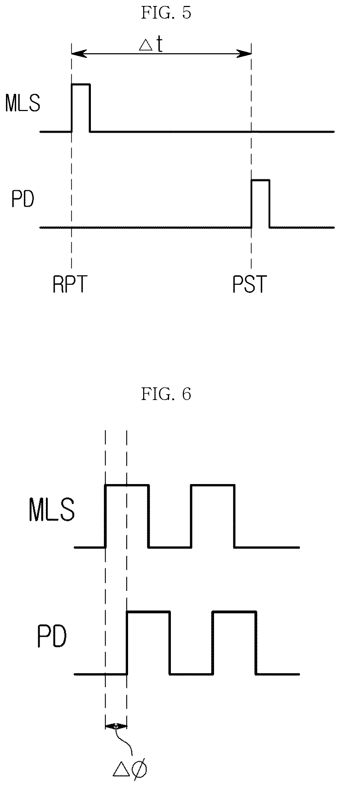

FIG. 5 illustrates the direct ToF method of the pixel (SP).

Referring to FIGS. 1 to 5, the light source LS may irradiate the first light beam L1 (or the irradiation light) to the target object (TO) by a reference pulse signal MLS in a state in which the image sensing device 100 is activated. A time point when a pulse of the reference pulse signal MLS is generated may be defined as a reference pulse time point (RPT). The pixel array 110 and the readout circuit 150 may detect a pulse signal reflected from the target object (TO) and becoming incident and generate pixel data PD.

The image signal processor 200 may process pixel data PD input from the image sensing device 100, and generate a depth image (in the form of a histogram) indicating a distance to the target object (TO). When the direct ToF method is applied, the image signal processor 200 may calculate a distance to the target object (TO) per pixel based on a time delay indicated by pixel data (PD) received from the readout circuit 150. The image signal processor 200 may analyze the pixel data PD, and may determine a time point when the pixel data PD has a value equal to or greater than threshold data to be a time point of pulse detection PST. The description of the value of the pixel data PD equal to or greater than threshold data will be provided below. The image signal processor 200 may calculate a time of flight Δt (ToF) which is a time gap from the reference pulse time point (RPT) to the time point of pulse detection (PST), and calculate the calculated time of flight Δt and the light velocity (e.g., a value obtained by dividing Δt by 2 is multiplied by the light velocity) so as to calculate a distance between the target object TO and the image sensing device 100.

FIG. 6 illustrates the indirect ToF method of the pixel (SP).

Referring to FIGS. 1 to 6, the light source LS may irradiate the first light beam L1 (or the irradiation light) to the target object (TO) by a reference pulse signal MLS in a state in which the image sensing device 100 is activated. A time point when a pulse of the reference pulse signal MLS is generated may be defined as a reference pulse time point (RPT). The pixel array 110 and the readout circuit 150 may detect a pulse signal reflected from the target object (TO) and becoming incident and generate pixel data PD.

The image signal processor 200 may process pixel data PD input from the image sensing device 100, and generate a depth image (in the form of a histogram) indicating a distance to the target object (TO). When the indirect ToF method is applied, the image signal processor 200 may calculate a distance to the target object (TO) per pixel based on a phase delay Δφ indicated by pixel data (PD) received from the readout circuit 150.

Hereinafter, for convenience of description, the disclosed technology will be described centering on the direct ToF method.

FIG. 7 illustrates the imaging system based on an embodiment.

Referring to FIG. 7, the imaging system based on an embodiment may include the single photon avalanche diode SPAD, the analog quenching transistor QX, a readout transistor RT, the readout circuit 150, and an ISP 200. An anode electrode AND may be formed in one end of the single photon avalanche diode SPAD, and a cathode electrode CAT may be formed on another end thereof. The anode electrode AND and the cathode electrode CAT are relative to each other, and positions thereof may be exchanged. For example, the anode electrode AND may be the second semiconductor region CD2 of the single photon avalanche diode SPAD, and the cathode electrode CAT may be the first semiconductor region CD1 of the single photon avalanche diode SPAD, but the disclosed technology is not limited thereto. A diode voltage VSPAD may be applied to the anode electrode AND of the single photon avalanche diode SPAD. The cathode electrode CAT may be connected to a first node N1. The second light beam L2 is applied to the single photon avalanche diode SPAD (refer to FIG. 4). The analog quenching transistor QX is connected to the first node N1. The analog quenching voltage VDD may be applied to a first electrode of the analog quenching transistor QX, a second electrode of the analog quenching transistor QX may be connected to the first node N1, a quenching control signal QCS may be applied to a gate electrode of the analog quenching transistor QX, and the analog quenching transistor QX may be controlled to turn on or off according to the quenching control signal QCS.

A readout transistor RT may be connected to the first node N1. A first electrode of the readout transistor RT may be connected to the first node N1, a second electrode thereof may be connected to the readout circuit 150, a readout control signal RCS may be applied to a gate electrode of the readout transistor RT, and the readout transistor RT may be controlled to turn on or off according to the readout control signal RCS.

FIG. 8 illustrates a mode of the single photon avalanche diode based on an embodiment. A horizontal axis in FIG. 8 shows a voltage VR applied to the single photon avalanche diode (refer to SPAD in FIG. 7), and a vertical axis therein shows a current IR output from the single photon avalanche diode (refer to SPAD in FIG. 7).

Referring to FIGS. 7 and 8, modes of the single photon avalanche diode may include a linear mode at a reverse bias voltage below the breakdown threshold voltage to produce an output current that is proportionally related to the intensity of the incident light containing multiple photons and a Geiger mode to detect a single photon. The linear mode and the Geiger mode of the single photon avalanche diode may be selected based on the breakdown voltage VBV. When a voltage applied to the single photon avalanche diode SPAD (hereinafter, referred to as the diode SPAD) is equal to or greater than the breakdown voltage VBV, the diode SPAD may operate in the Geiger mode, and when the voltage applied to the single photon avalanche diode SPAD is smaller than the breakdown voltage VBV, the diode SPAD may operate in the linear mode. The voltage VR applied to the diode SPAD may be based on a negative (-) voltage. Therefore, it is assumed in the disclosed technology that the greater the negative (-) value, the greater the magnitude of the voltage. However, the disclosed technology is not limited thereto. In the linear mode and the Geiger mode, the diode voltage VSPAD may have a constant magnitude.

For example, the diode voltage VSPAD may be set to have a voltage smaller than the breakdown voltage VBV. When the diode voltage VSPAD is greater than the breakdown voltage VBV, the diode SPAD may become capable of entering the Geiger mode, even if the analog quenching transistor QX is not turned on. In this case, even if the light L2 is not applied, the avalanche is generated randomly, and a great current IR may be generated from the diode SPAD. Therefore, the diode voltage VSPAD may be preferably set to have a voltage smaller than the breakdown voltage VBV.

For further description of the Geiger mode and the Linear mode, a magnitude of each voltage will be taken as an example. The breakdown voltage VBV may be -20V, and the diode voltage VSPAD may be -19V. When the analog quenching transistor QX is turned off, a voltage applied to the diode SPAD is -19V and is smaller than the breakdown voltage VBV, and the diode SPAD operates in the Linear mode. In the Linear mode, even if the light L2 is incident to the diode SPAD, a magnitude of the current IR output from the diode SPAD may not be great, and the quantity of the carriers may not be many, although the magnitude of the current IR increases in proportion to the quantity of the carriers (e- or h+) generated by the impact ionization. Even if the analog quenching transistor QX is turned on, when the analog quenching voltage VDD is smaller than 1V, the voltage VR applied to the diode SPAD is -19V (a voltage smaller than 1V), which is smaller than the breakdown voltage VBV, and therefore, the diode SPAD operates in the Linear mode.

### Reset Operation

In a reset operation ("③" in FIG. 8), when an analog quenching voltage VDD of 1V is applied, the voltage VR applied to the diode SPAD becomes equal to the breakdown voltage VBV. From this time, the diode SPAD operates in the Geiger mode. In the Geiger mode, as the voltage VR applied to the diode SPAD increases, the magnitude of the current IR output from the diode SPAD dramatically increases. However, in the reset operation ("③" in FIG. 8), when the voltage VR applied to the diode SPAD is set to be equal to the breakdown voltage VBV, the diode SPAD may operate in the Linear mode, rather than the Geiger mode, because of some error. Therefore, in the reset operation ("③" in FIG. 8), the voltage VR applied to the diode SPAD may be set up to an operating voltage VOP. For example, the operating voltage VOP may be greater than the breakdown voltage VBV, and for example, may be assumed to be -23V. That is, an operating voltage VOP greater than the breakdown voltage VBV is preset, and an operation to increase the voltage VR applied to the diode SPAD up to the operating voltage VOP through the analog quenching voltage VDD is performed in the reset operation ("③" in FIG. 8). In order to increase the voltage applied to the diode SPAD to -23V, which is the operating voltage VOP, the analog quenching voltage VDD must be 4V (-19V-4V=-23V). The voltage obtained by subtracting the breakdown voltage VBV from the operating voltage VOP may be a setting voltage VEX, and in this case, it may be -3V.

### Avalanche Operation

In the avalanche operation ("①" in FIG. 8), the impact ionization occurs for many times in the diode SPAD, and countless carriers are generated, and therefore, the magnitude of the current IR output from the diode SPAD may be great. That is, because the magnitude of the output current IR is great, an operation to generate a pulse signal reflected from the target object TO and becoming incident as described referring to FIG. 5 may be performed in the avalanche operation ("①" in FIG. 8) of the diode SPAD. The pulse signal generated from the diode SPAD is provided to the readout circuit 150 when the readout transistor RT is turned on. The TDC 151 of the readout circuit 150 generates the pixel data PD based on the pulse signal generated and provided from the diode SPAD, and the TDC buffer 153 stores the generated pixel data PD.

### Quenching Operation

In the quenching operation ("②" in FIG. 8), the analog quenching transistor QX is turned off, and because of this, the voltage VR applied to the diode SPAD may drop to a level of the diode voltage VSPAD again. The diode SPAD based on an embodiment repeats the reset operation ("③" in FIG. 8), the avalanche operation ("①" in FIG. 8), and the quenching operation ("②" in FIG. 8).

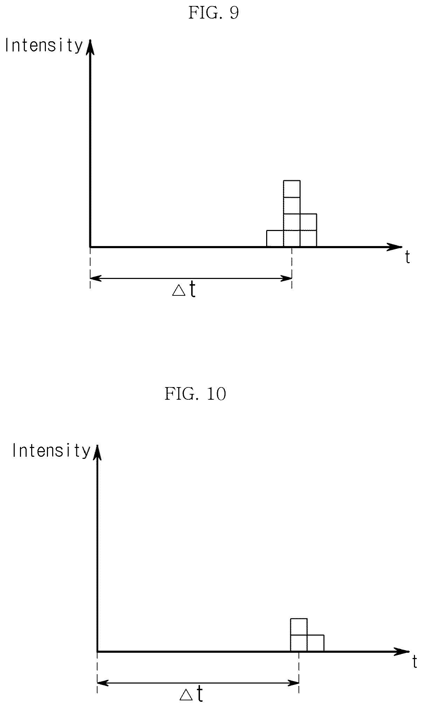

FIG. 9 is a graph converting pixel data generated by a second pixel (SP) based on an embodiment into a histogram. FIG. 10 is a graph converting pixel data generated by a fourth pixel (SP) based on an embodiment into a histogram. The horizontal axis in FIGS. 9 and 10 shows a time t, and the vertical axis thereof shows an intensity of the signal.

The pixel data PD is generated in the Geiger mode of the diode SPAD described referring to FIG. 7. The ISP (refer to 200 in FIG. 7) may convert the pixel data PD of each diode SPAD into a histogram. The diode SPAD of each pixel SP in FIGS. 9 and 10 generates a pulse signal exposed to the same illuminance condition and reflected from the target object (refer to TO in FIG. 1) positioned in the same distance and become incident.

Referring to FIGS, 3, 9 and 10, a diode SPAD of the second pixel SP2 may have a second width W2, a diode SPAD of the fourth pixel SP4 may have a fourth width W4 smaller than the second width W2. In general, the width of the diode SPAD and the intensity of the signal may be proportional to each other. That is, it may be considered that the greater the width of the diode SPAD, the higher the sensitivity of the diode SPAD. For example, the diodes SPAD of the first and the second pixels (SP1, PS2) may have the highest sensitivity, the diode SPAD of the third pixel (SP3) may have an intermediate sensitivity, and the diode SPAD of the fourth pixel (SP4) may have a low sensitivity, but the disclosed technology is not limited thereto. Therefore, as illustrated in FIGS. 9 and 10, based on the same illuminance condition, and the target object (refer to TO in FIG. 1) positioned in the same distance, the signal intensity of the pixel data PD generated by the diode SPAD of the second pixel (SP2) may be greater than the signal intensity of the pixel data PD generated by the diode SPAD of the fourth pixel (SP4).

The imaging system (refer to 1 in FIG. 1) based on an embodiment is characterized in that the diodes SPAD having the high sensitivity, the intermediate sensitivity, and the low sensitivity are selectively operated (receiving light through the corresponding diode SPAD) in the condition of each different illuminance. For example, in a low illuminance environment, a relatively great amount of light must be received, and thus, the diode SPAD having the high sensitivity is operated, and in a high illuminance environment, it is allowed that a relatively small amount of light can be received, therefore, the diode SPAD having the low sensitivity may be operated. In some embodiments, it may be possible to selectively operate the diode SPAD having the high sensitivity, the intermediate sensitivity, or the low sensitivity (receiving light through the corresponding diode SPAD) according to a distance to the target object (refer to TO in FIG. 1). For example, when the distance is relatively long, it is possible to operate the diode SPAD having the high sensitivity and when the distance is relatively short, it is possible to operate the diode SPAD having the low sensitivity.

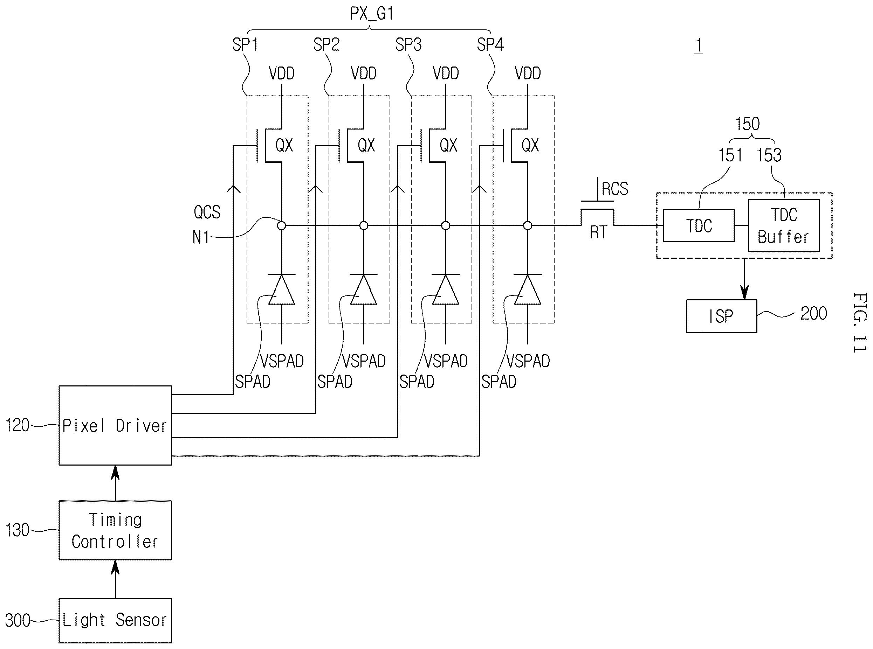

FIG. 11 is a view illustrating the imaging system based on an embodiment.

Referring to FIGS. 7 and 11, the imaging system 1 based on an embodiment may include the plurality of pixels (SP1, SP2, SP3, SP4). In FIG. 11, the first pixel group (PX_G1) is illustrated as an example, however, operations of the second pixel group (PX_G2) to the fourth pixel group (PX_G4) may be the same as that of the first pixel group (PX_G1).

The pixels (SP1, SP2, SP3, SP4) of the first pixel group (PX_G1) may be connected to one another. For example, each pixel (SP1, SP2, SP3, SP4) may share the first node N1. The gate electrode of the analog quenching transistor QX of each pixel (SP1, SP2, SP3, SP4) may be connected to the pixel driver 120, respectively. The pixel driver 120 may apply the quenching control signal QCS to the gate electrode of the analog quenching transistor QX of each pixel (SP1, SP2, SP3, SP4), thereby becoming able to control turn on/off of the analog quenching transistor QX of each pixel (SP1, SP2, SP3, SP4).

As described above, the imaging system 1 based on an embodiment is characterized in that the imaging system 1 selectively operates (receiving light through the corresponding diode SPAD) the diode SPAD having the high sensitivity, the intermediate sensitivity, or the low sensitivity in the condition of each different illuminance, therefore the pixel driver 120 can control turn on/off of the analog quenching transistor QX of each pixel (SP1, SP2, SP3, SP4) based on the illuminance of the surrounding environment determined by the light sensor 300. Accordingly, the light sensor 300 may sense the illuminance of the surrounding environment, determine whether the sensed illuminance is equal to or greater than a reference illuminance, or smaller than the reference illuminance, and may provide the determined result to the timing controller 130.

When the sensed illuminance is smaller than the reference illuminance, the timing controller 130 may provide a signal to turn on the analog quenching transistor QX of the first pixel (SP1) or the second pixel (SP2) to the pixel driver 120, and when the sensed illuminance is equal to or greater than the reference illuminance, the timing controller 130 may provide a signal to turn on the analog quenching transistor QX of the fourth pixel (SP4) to the pixel driver 120.

In some embodiments, the reference illuminance sensed by the light sensor 300 may be a plural number with two or more different reference illuminance levels. For example, the reference illuminance may include a first reference illuminance, a second reference illuminance greater than the first reference illuminance. When the sensed illuminance is smaller than the first reference illuminance, the timing controller 130 may provide a signal to turn on the analog quenching transistor QX of the first pixel (SP1) or the second pixel (SP2) to the pixel driver 120. When the sensed illuminance is equal to or greater than the first reference illuminance and smaller than the second reference illuminance, the timing controller 130 may provide a signal to turn on the analog quenching transistor QX of the third pixel (SP3) to the pixel driver 120. When the sensed illuminance is equal to or greater than the second reference illuminance, the timing controller 130 may provide a signal to turn on the analog quenching transistor QX of the fourth pixel (SP4) to the pixel driver 120. Hereinafter, for convenience of description, the disclosed technology will be described centering on a case where there is one reference illuminance.

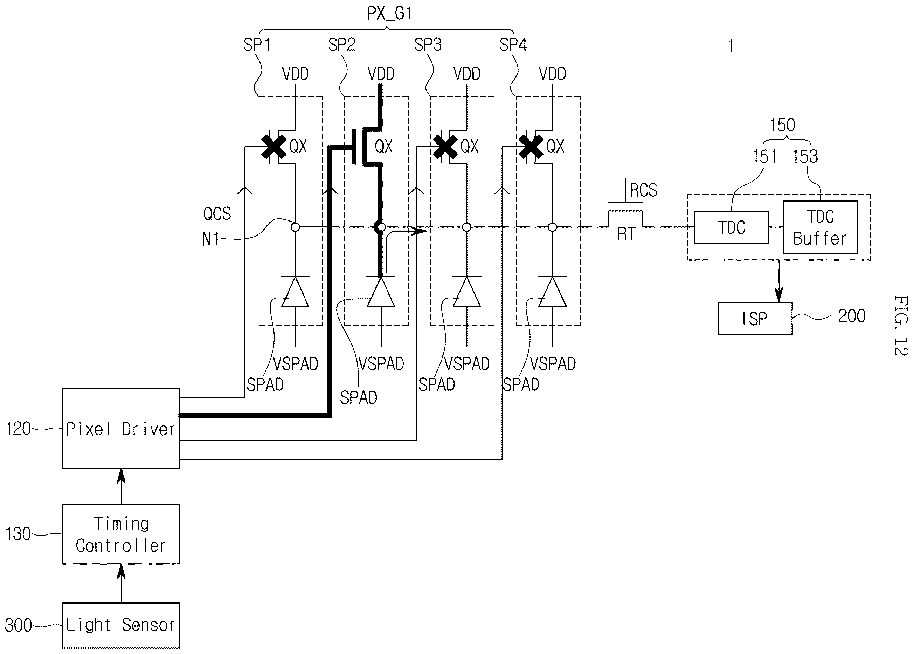

FIG. 12 is a view illustrating the imaging system under illuminance less than the reference illuminance value.

Referring to FIG. 12, when the illuminance of the surrounding environment is smaller than the reference illuminance, the pixel driver 120 may apply the quenching control signal QCS in a turn-on level to the analog quenching transistor QX of the second pixel SP2, and may apply the quenching control signal QCS in a turn-off level to the analog quenching transistor QX of the remaining pixels (SP1, SP3, SP4). As a result, the analog quenching transistor QX of the second pixel SP2 is turned on, and the analog quenching transistor QX of the remaining pixels (SP1, SP3, SP4) may be turned off. Therefore, a pulse signal (or a pixel signal) generated through the second light beam (refer to L2 in FIG. 1) reflected from the target object TO is generated from the diode SPAD of the second pixel (SP2) that is turned on, and the generated pulse signal may be provided to the readout circuit 150 through the readout transistor RT.

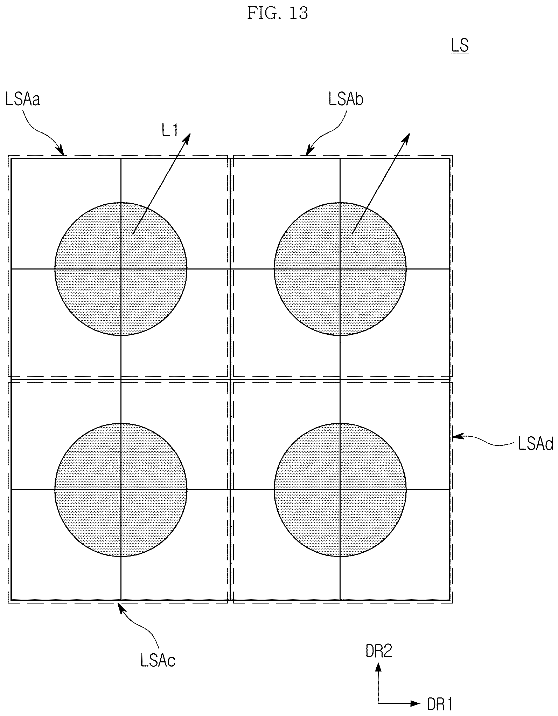

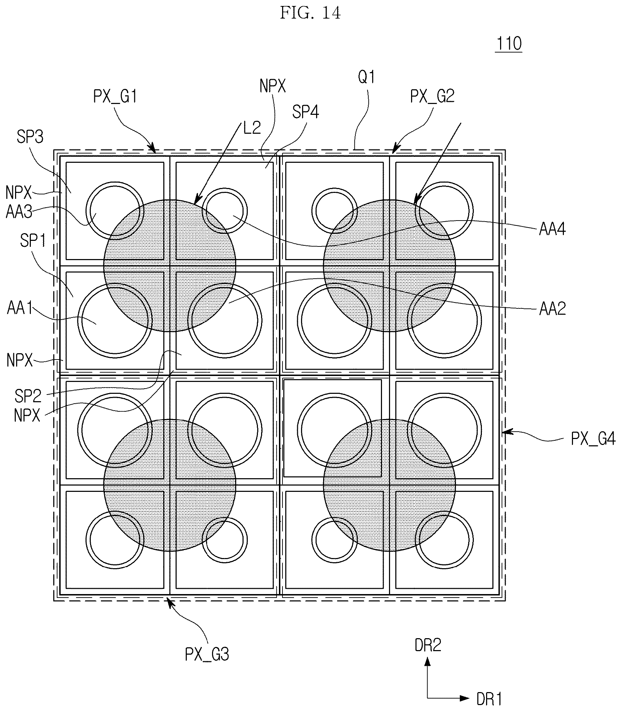

FIG. 13 is a plan view illustrating a channel region irradiating the first light beam of the light source based on an embodiment. FIG. 14 is a plan view illustrating irradiation of the second light beam to the pixel array based on an embodiment.

Referring to FIGS. 12 to 14, the light source LS may include a vertical cavity surface emitting laser (VCSEL), and the light source LS may include channel groups (LSAa, LSAb, LSAc, LSAd) corresponding to the pixel groups (pixel groups (PX_G1, PX_G2, PX_G3, PX_G4) in FIG. 3). In some embodiments of the disclosed technology, the fact that the channel of the light source LS corresponds to the pixel (SP) means that the first light beam L1 output from a corresponding channel is reflected from the target object TO, and becomes incident to a corresponding pixel (SP). For example, the first channel group (LSAa) may output the first light beam L1 in correspondence with the first pixel group (PX_G1), the second channel group (LSAb) may output the first light beam L1 in correspondence with the second pixel group (PX_G2), the third channel group (LSAc) may output the first light beam L1 in correspondence with the third pixel group (PX_G3), and the fourth channel group (LSAd) may output the first light beam L1 in correspondence with the fourth pixel group (PX_G4).

As described above referring to FIG. 12, in the imaging system 1 based on an embodiment, when the illuminance in the surrounding environment is smaller than the reference illuminance, the pixel driver 120 applies the quenching control signal QCS in a turn-on level to the analog quenching transistor QX of the second pixel (SP2), therefore, only the second pixels (SP2) of each of pixel group (PX_G1, PX_G2, PX_G3, PX_G4) in FIG. 3 operate.

As described above referring to FIG. 13, the light source LS based on an embodiment may output the second light beam L2 from all channels regardless of the operating pixels (SP1, SP2, SP3, SP4).

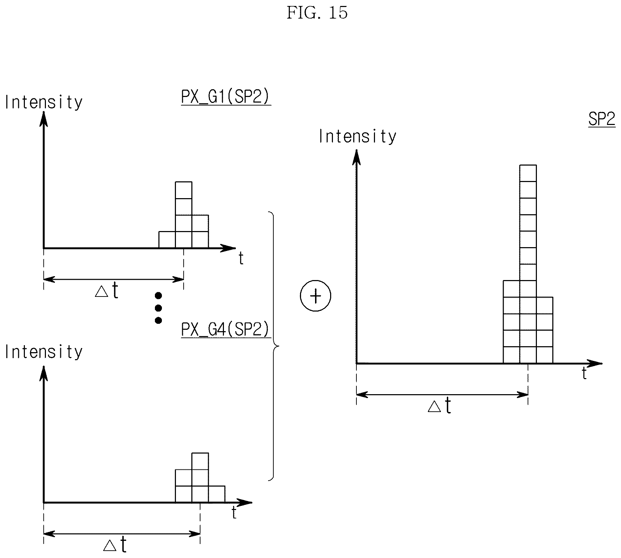

FIG. 15 is a graph illustrating a histogram obtained by summing pixel data generated by the second pixel (SP) of the pixel groups based on an embodiment.

Referring to FIG. 15, in the illuminance smaller than the reference illuminance, only the second pixel (SP2) of each of the pixel groups (PX_G1, PX_G2, PX_G3, PX_G4 in FIG. 3) operates, the second pixel (SP2) of each of the pixel groups (PX_G1, PX_G2, PX_G3, PX_G4) generates a pulse signal (or a pixel signal), respectively, and provides the generated pulse signal to the readout circuit (refer to 150 in FIG. 12). The readout circuit (refer to 150 in FIG. 12) converts the pulse signals generated by the second pixels (SP2) into the pixel data, and provides the pixel data to the ISP 200. The ISP 200 converts the received pixel data into the histogram (refer to a left drawing in FIG. 15), and adds up each of the converted pixel data (refer to a right drawing in FIG. 15).

In an embodiment, even if the illuminance in the surrounding environment is smaller than the reference illuminance, the imaging system can generate effective pixel data by receiving a large amount of the second light beam (refer to L2 in FIG. 14) through the diodes SPAD of the second pixel (SP2) of each pixel group (PX_G1, PX_G2, PX_G3, PX_G4) having the high sensitivity. In addition, because the pixel data generated from the second pixel (SP2) of each pixel group (PX_G1, PX_G2, PX_G3, PX_G4) is added up, it is possible to precisely sense a distance to the target object (refer to TO in FIG. 1) even in the environment having the low illuminance.

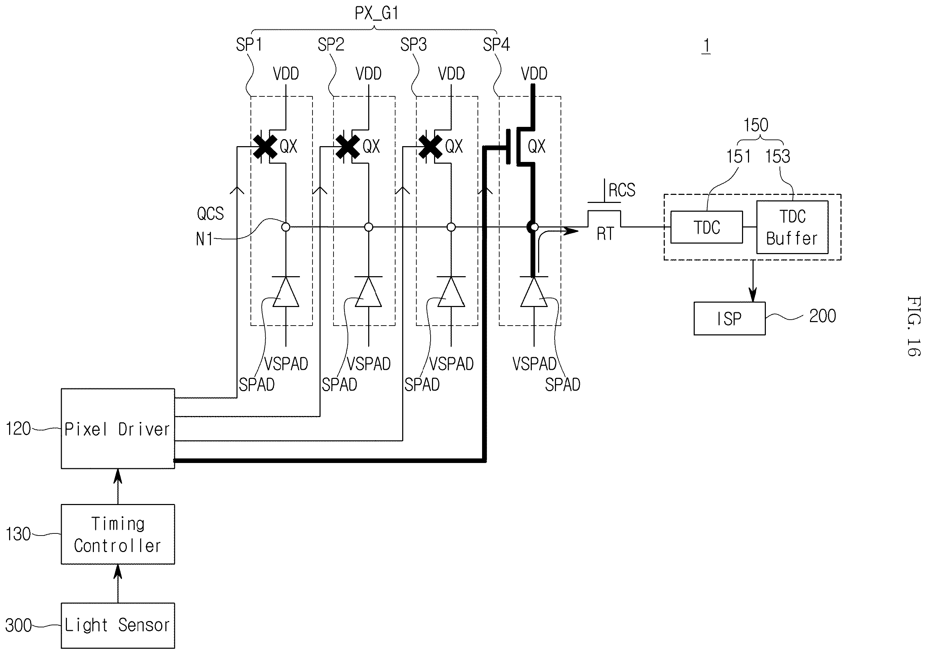

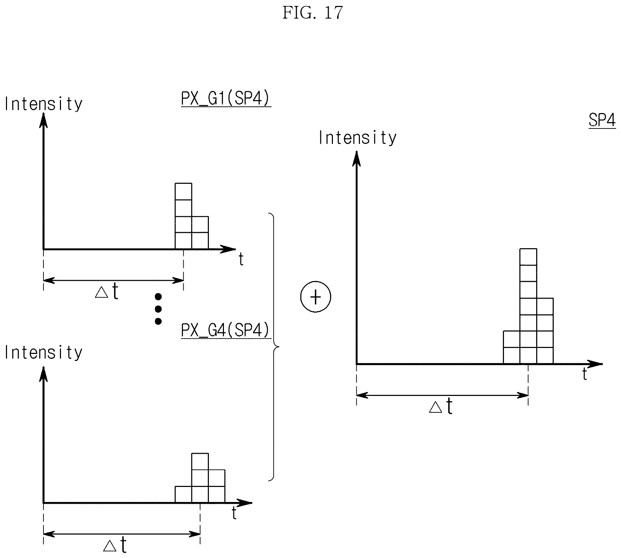

FIG. 16 is a view illustrating the imaging system under illuminance equal to or greater than the reference illuminance value. FIG. 17 is a graph illustrating the histogram obtained by summing pixel data generated by the fourth pixel (SP) of the pixel groups based on an embodiment.

Referring to FIGS. 16 and 17, in case when the illuminance in the surrounding environment is equal to or greater than the reference illuminance, the pixel driver 120 may apply the quenching control signal QCS in a turn-on level to the analog quenching transistor QX of the fourth pixel (SP4), and may apply the quenching control signal QCS in a turn-off level to the analog quenching transistors QX of the remaining pixels (SP1, SP2, SP3). As a result, the analog quenching transistor QX of the fourth pixel (SP4) may be turned on, and the analog quenching transistors QX of the remaining pixels (SP1, SP2, SP3) may be turned off. Therefore, a pulse signal (or a pixel signal) generated through the second light beam (refer to L2 in FIG. 1) reflected from the target object TO is generated from the diode SPAD of the fourth pixel (SP4) that is turned on, and the generated pulse signal may be provided to the readout circuit 150 through the readout transistor RT.

In the illuminance smaller than the reference illuminance, only the fourth pixel (SP4) of each pixel group (PX_G1, PX_G2, PX_G3, PX_G4 in FIG. 3) operates, the fourth pixel (SP4) of each of the pixel groups (PX_G1, PX_G2, PX_G3, PX_G4) generates a pulse signal (or a pixel signal), respectively, and provides the generated pulse signal to the readout circuit 150. The readout circuit (refer to 150 in FIG. 12) converts the pulse signals generated by the fourth pixels (SP4) into the pixel data, and provides the pixel data to the ISP 200. The ISP 200 converts the received pixel data into the histogram (refer to a left drawing in FIG. 17), and adds up each of the converted pixel data (refer to a right drawing in FIG. 17).

In an embodiment, when the illuminance is equal to or greater than the reference illuminance, the imaging system can generate effective pixel data by receiving a small amount of the second light beam (refer to L2 in FIG. 14) through the diodes SPAD of the fourth pixel (SP4) of each pixel group (PX_G1, PX_G2, PX_G3, PX_G4) having the low sensitivity. As described referring to FIG. 8, a current IR output from the diode SPAD in the Geiger mode may have a dramatically great magnitude. Therefore, in an environment having the high illuminance, a great number of signals may be output (noise may be output together), and reduction of the second light beam L2 being received may be necessary.

In addition, because the pixel data generated from the fourth pixel (SP4) of each pixel group (PX_G1, PX_G2, PX_G3, PX_G4) is added up, it is possible to precisely sense a distance to the target object (refer to TO in FIG. 1).

Hereinafter, the imaging system based on another embodiment will be described. While describing the embodiments, redundant description or detailed description on the reference numerals or configuration which have been described with reference to FIGS. 1 to 17 will be omitted.

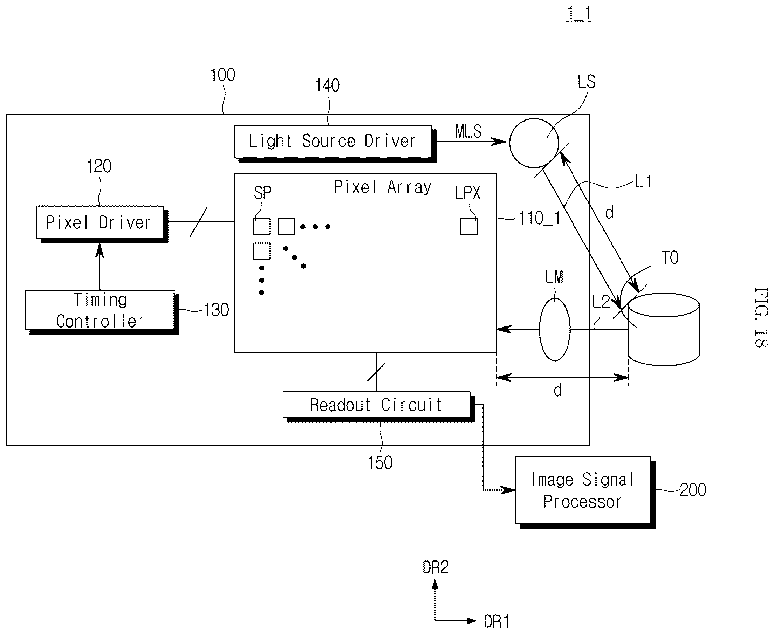

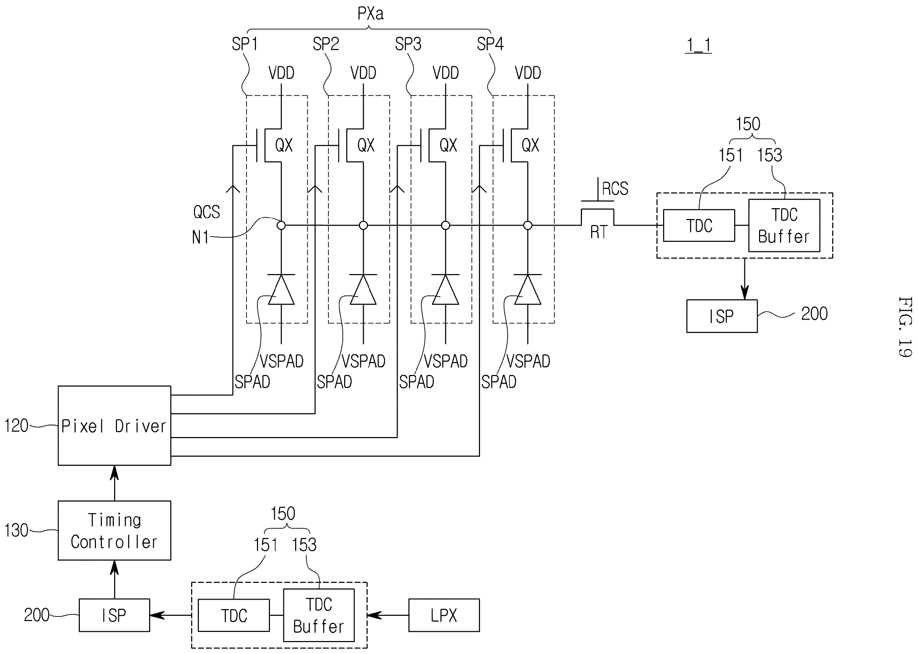

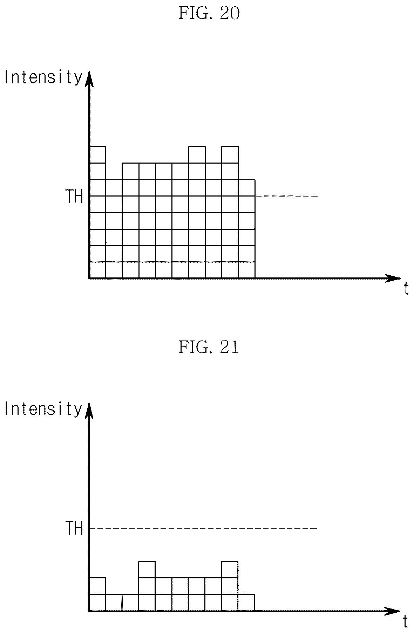

FIG. 18 is a block diagram illustrating the imaging system based on another embodiment. FIG. 19 is a view illustrating the imaging system based on another embodiment. FIGS. 20 and 21 are graphs illustrating histograms of pixel data generated by the illuminance pixel (SP).

Referring to FIGS. 18 to 21, an imaging system 1_1 according to the present embodiment is different from the imaging system 1 according to FIGS. 1 and 11 in that the imaging system 1_1 has the light sensor 300 disposed (refer to LPX) inside a pixel array 110_1.

In some implementations, the light sensor LPX is disposed inside the pixel array 110_1, and may be formed in a form of the single photon avalanche diode similar to the pixel. In FIG. 18, a case where there is one light sensor LPX is taken as an example, however, the disclosed technology is not limited thereto, and there may be a plurality of light sensors LPX. In addition, although it is illustrated that the light sensor LPX is disposed on an outer side of the pixel array 110_1, the disclosed technology is not limited thereto, and the light sensor LPX may be disposed between the pixels (SP1, SP2, SP3, SP4).

As illustrated in FIG. 19, the light sensor LPX senses the illuminance in the surrounding environment, and provides the sensed result (in the form of the pulse signal) to the readout circuit 150. The readout circuit 150 generates the pixel data based on the pulse signal (or the pixel signal) provided from the light sensor LPX, and provides the pixel data to the ISP 200.

As illustrated in FIGS. 20 and 21, the light sensor LPX may sense the illuminance in the surrounding environment during a certain period of time, and the ISP 200 may determine that the average illuminance is equal to or greater than the reference illuminance TH (refer to FIG. 20), or that the average illuminance is smaller than the reference illuminance TH (refer to FIG. 21). When the average illuminance is equal to or greater than the reference illuminance TH, the timing controller 130 may provide a signal to turn on the analog quenching transistor QX of the fourth pixel (SP4) to the pixel driver 120, and when the average illuminance is smaller than the reference illuminance TH, the timing controller 130 may provide a signal to turn on the analog quenching transistor QX of the first pixel (SP1) or the second pixel (SP2) to the pixel driver 120.

In some embodiments, when the distance is relatively long, it is possible to operate the diode SPAD having the high sensitivity and when the distance is relatively short, it is possible to operate the diode SPAD having the low sensitivity.

For example, referring to FIG. 16, the light sensor 300 is omitted and the fourth pixels (SP4) of each pixel group (refer to PX_G1 to PX_G4 in FIG. 3) may be operated. The pixel driver 120 may apply the quenching control signal QCS in a turn-on level to the analog quenching transistor QX of the fourth pixel SP4, and may apply the quenching control signal QCS in a turn-off level to the analog quenching transistor QX of the remaining pixels (SP1, SP2, SP3). Therefore, a pulse signal (or a pixel signal) generated through the second light beam (refer to L2 in FIG. 1) reflected from the target object TO is generated from the diode SPAD of the fourth pixel (SP4) that is turned on, and the generated pulse signal may be provided to the readout circuit 150 through the readout transistor RT. The readout circuit 150 converts the pulse signals generated by the fourth pixels (SP4) into the pixel data, and provides the pixel data to the ISP 200. The ISP 200 converts the received pixel data into the histogram, and adds up each of the converted pixel data. Further, the ISP 200 may determine whether the target object (refer to TO in FIG. 1) is positioned in the long distance or the short distance based on the pixel data added up. For example, when the pixel data added up is equal to or greater than a reference value or reference accuracy, it may be determined that the target object is positioned in the short distance, and when the pixel data added up is smaller than the reference value or reference accuracy, it may be determined that the target object is positioned in the long distance.

When the pixel data added up is equal to or greater than the reference value or reference accuracy, it is possible to measure a distance to the target object TO based on the pixel data generated by the fourth pixel (SP4) and added up, and when the pixel data added up is smaller than the reference value or reference accuracy, it is possible to operate the first or the second pixel (SP1, SP2), generate the pulse signal (or the pixel signal) again and provide the pulse signal to the readout circuit 150. The readout circuit 150 may convert the pulse signals generated by the first pixel (SP1) or the second pixel (SP2) into pixel data, respectively, provide the pixel data to the ISP 200. The ISP 200 converts each of the pixel data provided into the histogram, and adds up each of the converted pixel data. At this instance, it is possible to measure a distance to the target object TO based on the pixel data added up.

The disclosed technology can be implemented in some embodiments to provide the image sensing device and the imaging system as will be discussed below.

In an embodiment, an image sensing device may include: a first pixel group and a second pixel group, each of which includes a first pixel including a first active region with a first region size and a second pixel including a second active region with a second region size smaller than the first region size, and each of the first pixel and the second pixel may include an avalanche diode, an antireflective layer on the avalanche diode, and a light receiving pattern on the antireflective layer.

In the image sensing device based on various embodiments of the disclosed technology, the first pixel of the first pixel group and the first pixel of the second pixel group may be disposed to be adjacent to each other, and the second pixel of the first pixel group and the second pixel (SP) of the second pixel group may be disposed to be adjacent to each other.

In the image sensing device based on various embodiments of the disclosed technology, the avalanche diode may include a first semiconductor region, a second semiconductor region, and a substrate portion on the first semiconductor region and the second semiconductor region.

In the image sensing device based on various embodiments of the disclosed technology, the first pixel may further include an intermediate region between the first semiconductor region and the second semiconductor region.

In the image sensing device based on various embodiments of the disclosed technology, the first pixel may further include a second trench portion recessed into the substrate portion in a thickness direction.

In the image sensing device based on various embodiments of the disclosed technology, the image sensing device may further include: a non-pixel region surrounding each pixel, and a first trench portion may be disposed in the non-pixel region.

In the image sensing device based on various embodiments of the disclosed technology, the first pixel and the second pixel may include an analog quenching transistor turned on by a quenching control signal, and the avalanche diode connected to the analog quenching transistor.

In the image sensing device based on various embodiments of the disclosed technology, an analog quenching voltage is applied to a first electrode of the analog quenching transistor, a second electrode thereof may be connected to the avalanche diode, and a gate electrode thereof may be controlled by the quenching control signal.

In the image sensing device based on various embodiments of the disclosed technology, the image sensing device may further include: a light sensor, and when the illuminance of a surrounding environment is equal to or greater than a reference illuminance, the analog quenching transistor of the second pixel of the first pixel group and the analog quenching transistor of the second pixel of the second pixel group may be turned on by the light sensor.

In the image sensing device based on various embodiments of the disclosed technology, when the illuminance of a surrounding environment is smaller than a reference illuminance, the analog quenching transistor of the first pixel of the first pixel group and the analog quenching transistor of the first pixel of the second pixel group may be turned on by the light sensor.

In the image sensing device based on various embodiments of the disclosed technology, the light sensor may be disposed in a form of the avalanche diode.

In the image sensing device based on various embodiments of the disclosed technology, the first pixel and the second pixel of the first pixel group may be electrically connected, and the first pixel and the second pixel of the second pixel group may be electrically connected.

In the image sensing device based on various embodiments of the disclosed technology, a first pixel and a second pixel (SP) of each pixel group may be selectively turned on/off according to the illuminance of a surrounding environment.

In another embodiment, an imaging system may include: a light source configured to irradiate a first light beam to a target object; and an image sensing device including a first pixel group and a second pixel group, each of which including a first pixel including a first active region having a first region size and a second pixel including a second active region having a second region size smaller than the first region size, and each of the first pixel and the second pixel may receive a second light beam reflected by the target object, the first pixel of the first pixel group and the first pixel of the second pixel group may be disposed to be adjacent to each other, and the second pixel of the first pixel group and the second pixel of the second pixel group may be disposed to be adjacent to each other.

In the imaging system based on various embodiments of the disclosed technology, the first pixel and the second pixel of the first pixel group may be electrically connected, and the first pixel and the second pixel of the second pixel group may be electrically connected.

In the imaging system based on various embodiments of the disclosed technology, a first pixel and a second pixel of each pixel group may be selectively turned on/off according to the illuminance of a surrounding environment.

In the imaging system based on various embodiments of the disclosed technology, the light source may irradiate the first light beam to the target object to correspond to a first pixel or a second pixel of each pixel group which is selectively turned on.

In the imaging system based on various embodiments of the disclosed technology, the imaging system may further include: a readout circuit configured to calculate a time delay between a pulse signal output from a first pixel or a second pixel of each pixel group which is electively turned on and a reference pulse, and to generate and store pixel data corresponding to a time delay.

In the imaging system according to various embodiments of the disclosed technology, the imaging system may further include: an image signal processor configured to process pixel data input from the readout circuit and to generate a depth image indicating a distance to the target object.

In the imaging system based on various embodiments of the disclosed technology, each of the first pixel and the second pixel may include an avalanche diode, and the avalanche diode may include a first semiconductor region, a second semiconductor region, and a substrate portion on the first semiconductor region and the second semiconductor region.

Only a few implementations and examples of the disclosed technology are described and other implementations, enhancements and variations can be made based on what is described and illustrated in this patent document.

## Claims

1. An image sensing device, comprising:
a first pixel group and a second pixel group, each of the first pixel group and the second pixel group including a first pixel that includes a first active region with a first region size and a second pixel that includes a second active region with a second region size smaller than the first region size,
wherein each of the first pixel and the second pixel includes an avalanche diode, an antireflective layer disposed on the avalanche diode, and a light receiving pattern disposed on the antireflective layer.

2. The image sensing device of claim 1,
wherein the first pixel of the first pixel group and the first pixel of the second pixel group are disposed to be adjacent to each other, and the second pixel of the first pixel group and the second pixel of the second pixel group are disposed to be adjacent to each other.

3. The image sensing device of claim 1,
wherein the avalanche diode includes a first semiconductor region, a second semiconductor region, and a substrate portion on the first semiconductor region and the second semiconductor region.

4. The image sensing device of claim 3,
wherein each of the first pixel of the first pixel group and the first pixel of the second pixel group further includes an intermediate region between the first semiconductor region and the second semiconductor region.

5. The image sensing device of claim 3,
wherein the first pixel further includes a second trench portion recessed into the substrate portion in a thickness direction.

6. The image sensing device of claim 1, further comprising:
a non-pixel region surrounding each pixel,
wherein a first trench portion is disposed in the non-pixel region.

7. The image sensing device of claim 1,
wherein each of the first pixel and the second pixel includes an analog quenching transistor configured to be turned on by a quenching control signal, wherein the avalanche diode in each of the first pixel and the second pixel is electrically connected to the analog quenching transistor.

8. The image sensing device of claim 7,
wherein the analog quenching transistor includes: a first electrode configured to be applied with an analog quenching voltage; a second electrode electrically connected to the avalanche diode; and a gate electrode configured to be controlled by the quenching control signal.

9. The image sensing device of claim 7, further comprising:
a light sensor configured to detect light,
wherein in response to an illuminance value of an environment around the light sensor beings equal to or greater than a reference illuminance value, the analog quenching transistor of the second pixel of the first pixel group and the analog quenching transistor of the second pixel of the second pixel group are turned on by the light sensor based on the detected light.

10. The image sensing device of claim 9,
wherein in response to an illuminance value of the environment around the light sensor being smaller than the reference illuminance value, the analog quenching transistor of the first pixel of the first pixel group and the analog quenching transistor of the first pixel of the second pixel group are turned on by the light sensor based on the detected light.

11. The image sensing device of claim 9,
wherein the light sensor includes an avalanche diode.

12. The image sensing device of claim 1,
wherein the first pixel and the second pixel of the first pixel group are electrically connected to each other, and the first pixel and the second pixel of the second pixel group are electrically connected to each other,
wherein a first pixel and a second pixel of each pixel group are selectively turned on or off according to an illuminance value of an environment around the image sensing device,
wherein the first pixel and the second pixel of each pixel group are selectively turned on or off according to a distance to a target object.

13. An imaging system, comprising:
a light source configured to emit a first light beam to illuminate a target object; and
the image sensing device according to any of the claims 1-14.

14. The imaging system of claim 13, further comprising:
a readout circuit configured to calculate a time delay between (1) a pulse signal output from either the first pixel or the second pixel of each pixel group that is selectively turned on and (2) a reference pulse, and to generate and store pixel data corresponding to the time delay.

15. The imaging system of claim 14, further comprising:
an image signal processor configured to process the pixel data generated by the readout circuit, and generate a depth image indicating a distance to the target object.
